# EUROPÄISCHE PATENTSCHRIFT

(11) **EP 2 986 092 B1**
(45) Veröffentlichungstag und Bekanntmachung des Hinweises auf die Patenterteilung: **11.10.2017**
(21) Anmeldenummer: 14180682.8
(22) Anmeldetag: 12.08.2014
(51) Int. Cl.: H02B 1/30, H05K 7/14

(54) **Schaltschrank**
Switchboard cabinet
Armoire pour convertisseur de puissance

(43) Veröffentlichungstag der Anmeldung: 17.02.2016
(73) Patentinhaber: SEMIKRON Elektronik GmbH & Co. KG, 90431 Nürnberg (DE)
(72) Erfinder: Gaumon, Aurèlien, 75009 Paris (FR); Lissilour, Yann, 75018 Paris (FR); Touzard, Sébastien, 27420 Château-sur-epte (FR)

(56) Entgegenhaltungen:
- EP-A2- 1 815 486
- EP-A2- 2 325 990
- DE-A1- 19 711 016
- US-A1- 2014 192 455

## Beschreibung

Die Erfindung betrifft einen Schaltschrank.

Stromrichtereinrichtungen, wie z.B. Wechselrichter, Gleichrichter oder Umrichter, werden im Allgemeinen in einem Schaltschrank montiert. Dabei müssen oftmals die Gleichspannungspotentialanschlusselemente, welche eine Gleichspannung führen, die von den Stromrichtereinrichtungen z.B. in eine Wechselspannung wechselgerichtet werden, im Schaltschrank miteinander elektrisch leitend verbunden werden. Die Stromrichtereinrichtungen sind häufig über ihre Gleichspannungspotentialanschlusselemente mit einen gemeinsamen Zwischenkreiskondensator elektrisch leitend verbunden.

Wenn in einer der Stromrichtereinrichtungen des Schaltschranks ein Fehler auftritt, dann muss die betreffende fehlerhafte Stromrichtereinrichtung des Schaltschranks ausgetauscht werden. Der Austausch soll dabei schnell und einfach durchführbar sein.

Aus der EP 1 815 486 B1 ist ein Verbindungsystem zwischen Kondensatorbänken, die mit einem Stromkreis verbunden sind, bekannt.

Es ist Aufgabe der Erfindung einen Schaltschrank mit Stromrichtereinrichtungen zu schaffen, bei dem die Stromrichtereinrichtungen schnell und einfach ausgetauscht werden können.

Diese Aufgabe wird gelöst durch einen Schaltschrank mit einem Schrankgestell und mit einer ersten und einer zweiten im Schaltschrank angeordneten Stromrichtereinrichtung, die vom Schrankgestell getragen werden und mit einer elektrischen Verbindungsklemmeinrichtung, wobei die erste Stromrichtereinrichtung erste Leistungshalbleiterbauelemente und zur elektrischen Verbindung der ersten Stromrichtereinrichtung ein erstes Gleichspanungspositivpotentialanschlusselement und ein erstes Gleichspanungsnegativpotentialanschlusselement aufweist, wobei zwischen dem ersten Gleichspanungspositivpotentialanschlusselement und dem ersten Gleichspanungsnegativpotentialanschlusselement ein elektrisch nicht leitendes erstes Isolationselement angeordnet ist, wobei die zweite Stromrichtereinrichtung zweite Leistungshalbleiterbauelemente und zur elektrischen Verbindung der zweiten Stromrichtereinrichtung ein zweites Gleichspanungspositivpotentialanschlusselement und ein zweites Gleichspanungsnegativpotentialanschlusselement aufweist, wobei zwischen dem zweiten Gleichspanungspositivpotentialanschlusselement und dem zweiten Gleichspanungsnegativpotentialanschlusselement ein elektrisch nicht leitendes zweites Isolationselement angeordnet ist, wobei die Verbindungsklemmeinrichtung ein elektrisch leitendes erstes Klemmelement und ein elektrisch leitendes vom ersten Klemmelement elektrisch isoliert angeordnetes zweites Klemmelement und eine Druckerzeugungseinrichtung, die zum Erzeugen eines Drucks, der das zweite Klemmelement in Richtung auf das erste Klemmelement drückt, ausgebildet ist, aufweist, wobei die Druckerzeugungseinrichtung das zweite Klemmelement gegen das erste und zweite Gleichspanungspositivpotentialanschlusselement drückt, und über das erste Gleichspanungspositivpotentialanschlusselement und das erste Isolationselement das erste Gleichspanungsnegativpotentialanschlusselement gegen das erste Klemmelement drückt, und über das zweite Gleichspanungspositivpotentialanschlusselement und das zweite Isolationselement das zweite Gleichspanungsnegativpotentialanschlusselement gegen das erste Klemmelement drückt, wobei das erste Klemmelement über einen elektrisch nicht leitenden Isolationskörper vom Schrankgestell elektrisch isoliert mit dem Schrankgestell mechanisch verbunden ist.

Vorteilhafte Ausbildungen der Erfindung ergeben sich aus den abhängigen Ansprüchen.

Es erweist sich als vorteilhaft, wenn die erste Stromrichtereinrichtung eine erste Gleichspannungsverschienung aufweist, die eine elektrisch leitendes erstes Blechelement und ein elektrisch leitendes, vom ersten Blechelement elektrisch isoliert angeordnetes zweites Blechelement aufweist, wobei das erste Gleichspanungspositivpotentialanschlusselement einstückig mit dem ersten Blechelement der ersten Gleichspannungsverschienung ausgebildet ist und das erste Gleichspanungsnegativpotentialanschlusselement einstückig mit dem zweiten Blechelement der ersten Gleichspannungsverschienung ausgebildet ist, wobei die zweite Stromrichtereinrichtung eine zweite Gleichspannungsverschienung aufweist, die eine elektrisch leitendes erstes Blechelement und ein elektrisch leitendes, vom ersten Blechelement elektrisch isoliert angeordnetes zweites Blechelement aufweist, wobei das zweite Gleichspanungspositivpotentialanschlusselement einstückig mit dem ersten Blechelement der zweiten Gleichspannungsverschienung ausgebildet ist und das zweite Gleichspanungsnegativpotentialanschlusselement einstückig mit dem zweiten Blechelement der zweiten Gleichspannungsverschienung ausgebildet ist. Hierdurch wird eine besonders einfache und kompakte Ausbildung der Gleichspanungspotentialanschlusselemente erreicht.

Weiterhin erweist es sich als vorteilhaft, wenn das erste Klemmelement über den elektrisch nicht leitenden Isolationskörper vom Schrankgestell elektrisch isoliert mit dem Schrankgestell mechanisch verbunden ist, indem das erste Klemmelement mittels einer Schraubverbindung mit dem Isolationskörper verbunden ist und der Isolationskörper mittels einer weiteren Schraubverbindung mit dem Schrankgestell verbunden ist. Hierdurch wird auf besonderes einfache Art und Weise eine elektrisch isolierende mechanische Verbindung des ersten Klemmelements mit dem Schrankgestell erzielt.

Weiterhin erweist es sich als vorteilhaft, wenn die Druckerzeugungseinrichtung zur Erzeugung des Drucks eine erste Schraube aufweist, die das erste und zweite Klemmelement miteinander mechanisch verbindet, wobei die erste Schraube von dem ersten oder dem zweiten Klemmelement elektrisch isoliert angeordnet ist. Hierdurch wird eine besonders einfach aufgebaute Druckerzeugungseinrichtung geschaffen.

In diesem Zusammenhang erweist es sich als vorteilhaft, dass falls die erste Schraube von dem ersten Klemmelement elektrisch isoliert angeordnet ist, zwischen der ersten Schrauben und dem ersten Klemmelement ein der ersten Schraube zugeordneter elektrisch nicht leitender Isolationshohlkörper angeordnet ist, durch den die erste Schraube verläuft, und dass falls die erste Schrauben von dem zweiten Klemmelement elektrisch isoliert angeordnet ist, zwischen der ersten Schraube und dem zweiten Klemmelement ein der ersten Schraube zugeordneter elektrisch nicht leitender Isolationshohlkörper angeordnet ist, durch den die erste Schraube verläuft. Hierdurch wird auf besonderes einfache Art und Weise eine voneinander elektrisch isolierende Anordnung des ersten und zweiten Klemmelements erzielt.

Ferner erweist es sich als vorteilhaft, wenn das erste Klemmelement in Richtung des zweiten Klemmelements hervorstehende erste Auswölbungen aufweist und das zweite Klemmelement in Richtung des ersten Klemmelements hervorstehende zweite Auswölbungen aufweist. Hierdurch wird eine zuverlässige elektrische Kontaktierung des ersten und zweiten Klemmelements mit den Gleichspanungspotentialanschlusselementen erzielt.

Ferner erweist es sich als vorteilhaft, wenn die ersten und zweiten Auswölbungen an ihrer Oberfläche mit einer Riffelung versehen sind. Hierdurch wird eine besonders zuverlässige elektrische Kontaktierung des ersten und zweiten Klemmelements mit den Gleichspanungspotentialanschlusselementen erzielt.

Ausführungsbeispiele der Erfindung sind in den Figuren dargestellt und werden im Folgenden näher erläutert. Dabei zeigen:
- FIG 1: eine perspektivische Frontansicht eines erfindungsgemäßen Schaltschranks,
- FIG 2: eine perspektivische Frontansicht einer im Schaltschrank eingebauten Stromrichtereinrichtung,
- FIG 3: eine perspektivische Frontansicht einer ersten und zweiten Stromrichtereinrichtung und eine Verbindungsklemmeinrichtung,
- FIG 4: eine weitere perspektivische Frontansicht einer ersten Gleichspannungsverschienung der ersten Stromrichtereinrichtung und einer zweiten Gleichspannungsverschienung der zweiten Stromrichtereinrichtung, welche mit der Verbindungsklemmeinrichtung miteinander elektrisch kontaktiert sind,
- FIG 5: eine Seitenansicht der Verbindungsklemmeinrichtung und der in der Nähe der Verbindungsklemmeinrichtung im Schaltschrank angeordneten Elemente,
- FIG 6: eine Schnittansicht der Verbindungsklemmeinrichtung und der in der Nähe der Verbindungsklemmeinrichtung im Schaltschrank angeordneten Elemente,
- FIG 7: eine Seitenansicht eines ersten und zweiten Klemmelements der Verbindungsklemmeinrichtung und
- FIG 8: ein elektrisches Schaltbild eines Moduls einer ersten bzw. zweiten Stromrichtereinrichtung.

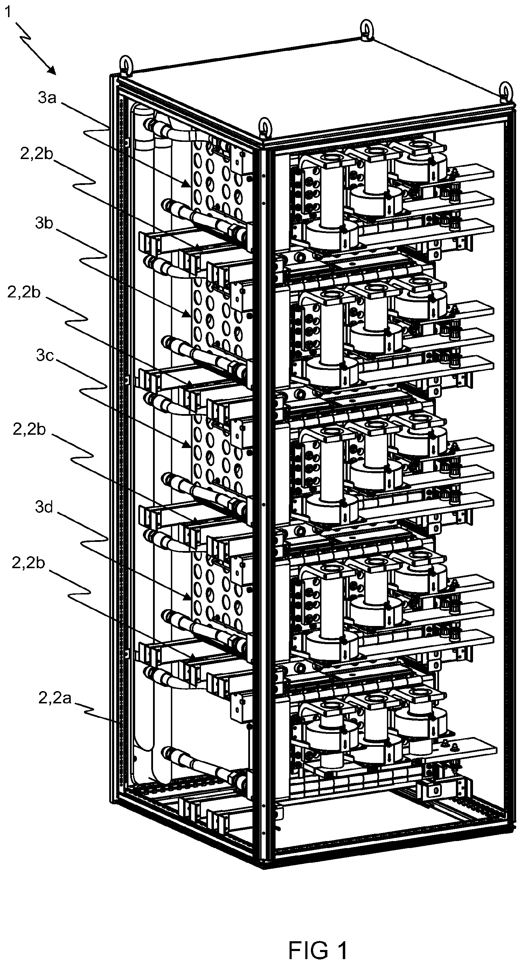

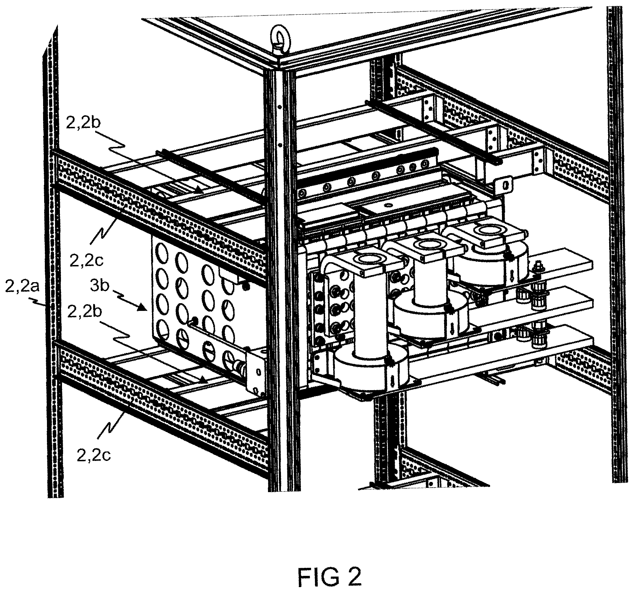

In FIG 1 ist eine perspektivische Frontansicht eines erfindungsgemäßen Schaltschranks 1 dargestellt. Der Schaltschrank 1 weist ein Schrankgestell 2 und eine erste, zweite, dritte und vierte im Schaltschrank 1 angeordnete Stromrichtereinrichtung 3a, 3b, 3c und 3d auf. Die Stromrichtereinrichtungen, sind im Rahmen des Ausführungsbeispiels als Wechselrichter ausgebildet, die eine Gleichspannung in eine 3-phasige Wechselspannung wechselrichten. Die Stromrichtereinrichtungen können z.B. auch als Gleichrichter oder Umrichter oder andersartige Stromrichter ausgebildet sein. Die erste, zweite, dritte und vierte Stromrichtereinrichtung 3a, 3b, 3c und 3d werden vom Schrankgestell 2 getragen. Im Rahmen des Ausführungsbeispiels weist das Schrankgestell 2 einen Schrankrahmen 2a, mit dem Schrankrahmen 2a verbundene Querstreben 2c (siehe FIG 2) und mit dem Querstreben 2c verbundene Tragelemente 2b auf, die die erste, zweite, dritte und vierte Stromrichtereinrichtung 3a, 3b, 3c und 3d tragen, wobei der Übersichtlichkeit halber in FIG 1 die Querstreben 2c nicht dargestellt sind und in FIG 2 nur die zweite Stromrichtereinrichtung 3b dargestellt ist.

Im Folgenden wird der Aufbau des Schaltschranks 1, insbesondere der Aufbau der Stromrichtereinrichtungen und der elektrischen Gleichspannungsverbindungen der Stromrichtereinrichtungen anhand der ersten und zweiten Stromrichtereinrichtung 3a und 3b beschrieben, wobei die übrigen Stromrichtereinrichtungen des Schaltschranks 1 im Rahmen des Ausführungsbeispiels in analoger Weise aufgebaut und miteinander elektrisch verbunden sind. Der erfindungsgemäße Schaltschranks 1 weist mindestens die erste und zweite Stromrichtereinrichtung 3a und 3b auf.

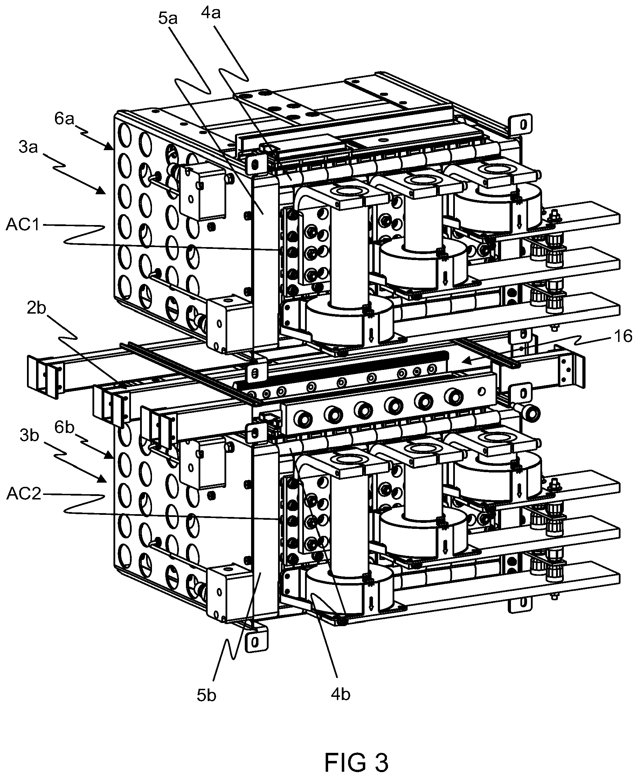

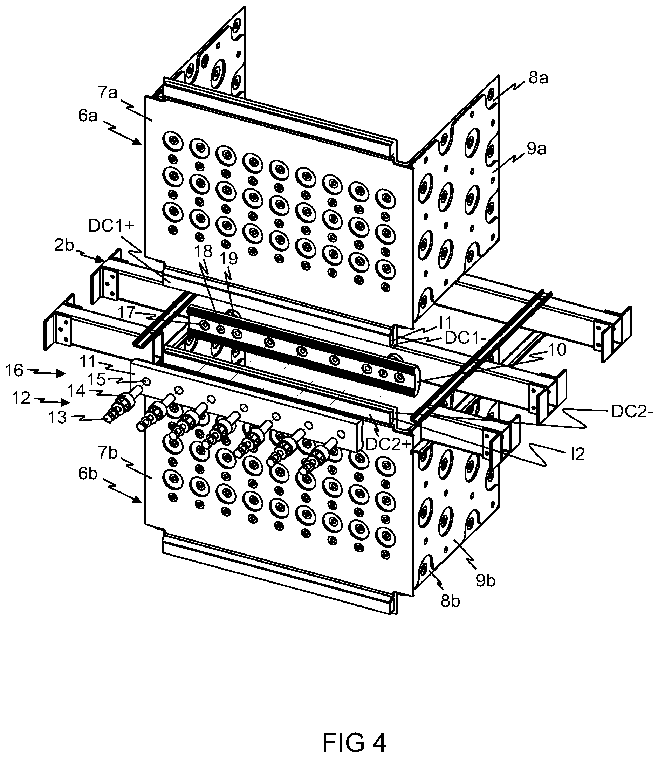

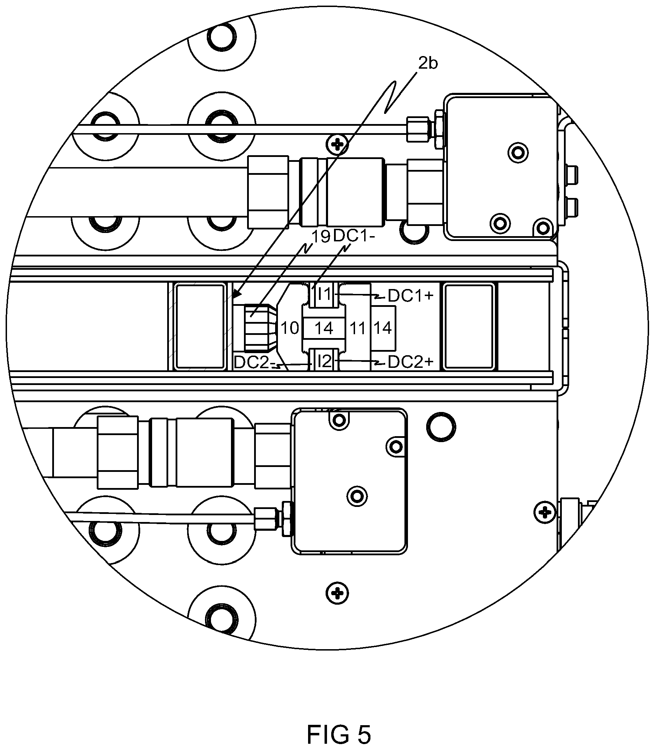

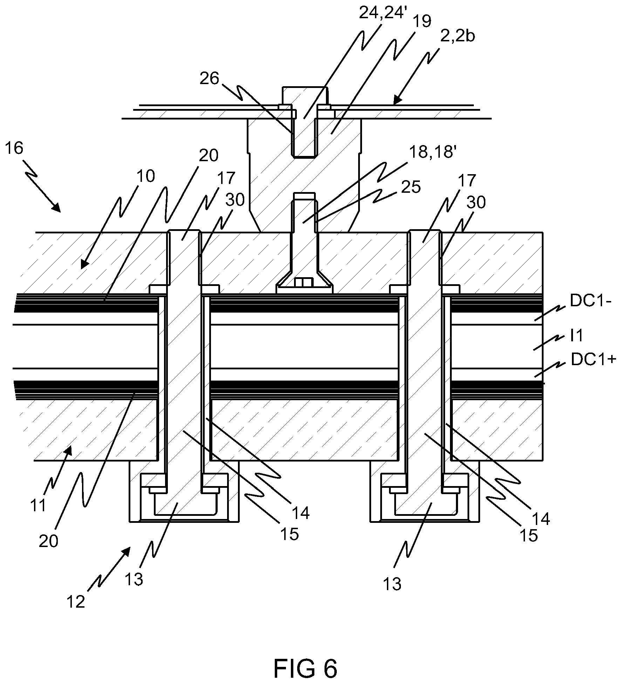

In FIG 3 ist eine perspektivische Frontansicht der ersten und zweiten Stromrichtereinrichtung 3a und 3b und einer elektrischen Verbindungsklemmeinrichtung 16 dargestellt. In FIG 4 ist eine weitere perspektivische Frontansicht einer ersten Gleichspannungsverschienung 6a der ersten Stromrichtereinrichtung 3a und einer zweiten Gleichspannungsverschienung 6b der zweiten Stromrichtereinrichtung 3b und der Verbindungsklemmeinrichtung 16 dargestellt, wobei die übrigen Elemente der ersten und zweiten Stromrichtereinrichtung 3a und 3b in FIG 4 nicht dargestellt sind. In FIG 5 ist eine Seitenansicht und in FIG 6 eine Schnittansicht der Verbindungsklemmeinrichtung 16 und der in der Nähe der Verbindungsklemmeinrichtung 16 im Schaltschrank 1 angeordneten Elemente dargestellt.

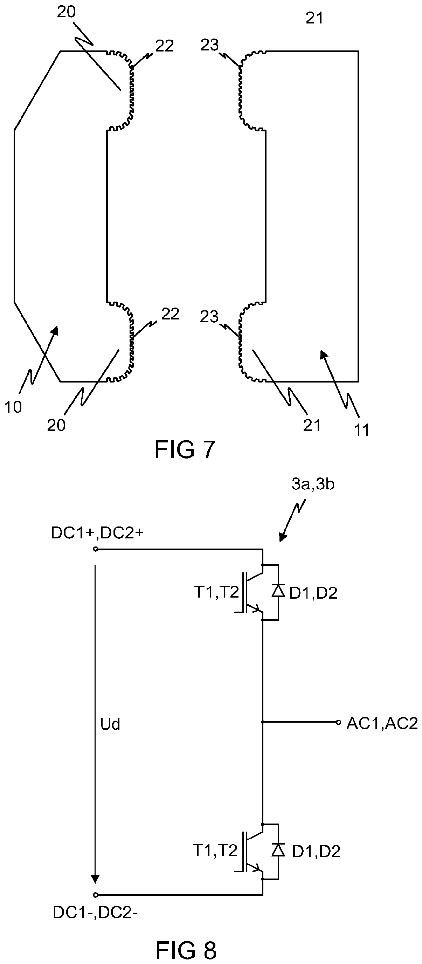

Im Rahmen des Ausführungsbeispiels weist die erste Stromrichtereinrichtung 3a mehrere in einem ersten Stromrichtereinrichtungsrahmen 5a angeordnete erste Module 4a und die die zweite Stromrichtereinrichtung 3b mehrere in einem zweiten Stromrichtereinrichtungsrahmen 5b angeordnete zweite Module 4b auf. Die ersten Module 4a weisen jeweilig erste Leistungshalbleiterbauelemente T1 bzw. D1 und die zweiten Module 4b weisen jeweilig zweite Leistungshalbleiterbauelemente T2 bzw. D2 auf. FIG 8 zeigt beispielhaft ein elektrisches Schaltbild eines ersten bzw. zweiten Moduls 4a bzw. 4b, das mit den jeweiligen Gleichspanungspotentialanschlusselementen DC1+, DC1- bzw. DC2+, DC2- der ersten und zweiten Stromrichtereinrichtung 3a bzw. 3b elektrisch leitend verbunden ist. Die ersten Module 4a weisen ausgangseitig jeweilig ein erstes Wechselspanungspotentialanschlusselement AC1 und die zweiten Module 4b weisen ausgangseitig jeweilig ein zweites Wechselspanungspotentialanschlusselement AC2 auf. Die Leistungshalbleiterbauelemente eines jeweiligen Moduls sind im Rahmen des Ausführungsbeispiels miteinander elektrisch zu einer Halbbrückenschaltung verschalten. Beim Ausführungsbeispiel sind dabei jeweilig drei in einem gemeinsamen Stromrichtereinrichtungsrahmen nebeneinander angeordnete Module elektrisch parallel geschaltet.

Bei der Erfindung liegt das jeweilige Leistungshalbleiterbauelement vorzugsweise jeweilig in Form eines Leistungshalbleiterunterschalters oder einer Leistungsdiode vor. Der jeweilige Leistungshalbleiterunterschalter liegt vorzugsweise in Form eines Transistors, wie z.B. eines IGBTs (Insulated Gate Bipolar Transistor) oder eines MOSFETs (Metal Oxide Semiconductor Field Effect Transistor) vor. Im Rahmen des Ausführungsbeispiels liegen die ersten und zweiten Leistungshalbleiterbauelemente in Form von IGBTs und Leistungsdioden vor.

Die erste Stromrichtereinrichtung 3a weist erste Leistungshalbleiterbauelemente T1 und D1 und zur elektrischen Verbindung der ersten Stromrichtereinrichtung 3a ein erstes Gleichspanungspositivpotentialanschlusselement DC1+ und ein erstes Gleichspanungsnegativpotentialanschlusselement DC1- auf, wobei zwischen dem ersten Gleichspanungspositivpotentialanschlusselement DC1+ und dem ersten Gleichspanungsnegativpotentialanschlusselement DC1- ein elektrisch nicht leitendes erstes Isolationselement I1 angeordnet ist, auf. Das erste Gleichspanungspositivpotentialanschlusselement DC1+ und das erste Gleichspanungsnegativpotentialanschlusselement DC1- ist verallgemeinert mit mindestens einem der ersten Leistungshalbleiterbauelemente elektrisch leitend verbunden. Die zweite Stromrichtereinrichtung 3b weist zweite Leistungshalbleiterbauelemente T2 und D2 und zur elektrischen Verbindung der zweiten Stromrichtereinrichtung 3b ein zweites Gleichspanungspositivpotentialanschlusselement DC2+ und ein zweites Gleichspanungsnegativpotentialanschlusselement DC2- auf, wobei zwischen dem zweiten Gleichspanungspositivpotentialanschlusselement DC2+ und dem zweiten Gleichspanungsnegativpotentialanschlusselement DC2- ein elektrisch nicht leitendes zweites Isolationselement I2 angeordnet ist. Das zweite Gleichspanungspositivpotentialanschlusselement DC2+ und das zweite Gleichspanungsnegativpotentialanschlusselement DC2- ist verallgemeinert mit mindestens einem der zweiten Leistungshalbleiterbauelemente elektrisch leitend verbunden.

Im Betrieb des Schaltschranks 1 weist das erste und zweite Gleichspanungspositivpotentialanschlusselement DC1+ und DC2+ eine positive elektrische Polarität auf und das erste und zweite Gleichspanungsnegativpotentialanschlusselement DC1- und DC2- eine negative elektrische Polarität auf, wobei zwischen dem ersten Gleichspanungspositivpotentialanschlusselement DC1+ und dem ersten Gleichspanungsnegativpotentialanschlusselement DC1-, und zwischen dem zweiten Gleichspanungspositivpotentialanschlusselement DC2+ und dem zweiten Gleichspanungsnegativpotentialanschlusselement DC2- eine Gleichspannung Ud, anliegt.

Im Rahmen des Ausführungsbeispiels weist die erste Stromrichtereinrichtung 3a eine erste Gleichspannungsverschienung 6a auf, die eine elektrisch leitendes erstes Blechelement 7a und ein elektrisch leitendes, vom ersten Blechelement 7a elektrisch isoliert angeordnetes, zweites Blechelement 8a auf, wobei vorzugsweise das erste Gleichspanungspositivpotentialanschlusselement DC1+ einstückig mit dem ersten Blechelement 7a der ersten Gleichspannungsverschienung 6a ausgebildet ist und vorzugsweise das erste Gleichspanungsnegativpotentialanschlusselement DC1-einstückig mit dem zweiten Blechelement 8a der ersten Gleichspannungsverschienung 6a ausgebildet ist. Zwischen dem ersten und zweiten Blechelement 7a und 8a der ersten Gleichspannungsverschienung 6a ist eine elektrisch nicht leitende erste Isolationsschicht 9a (z.B. eine Kunststofffolie) angeordnet. Die erste Isolationsschicht 9a kann zusätzlich zum ersten Isolationselement I1 zwischen dem ersten Gleichspanungspositivpotentialanschlusselement DC1+ und dem ersten Gleichspanungsnegativpotentialanschlusselement DC1- angeordnet sein.

Weiterhin weist im Rahmen des Ausführungsbeispiels die zweite Stromrichtereinrichtung 3b eine zweite Gleichspannungsverschienung 6b auf, die eine elektrisch leitendes erstes Blechelement 7b und ein elektrisch leitendes, vom ersten Blechelement 7b elektrisch isoliert angeordnetes zweites Blechelement 8b aufweist, wobei vorzugsweise das zweite Gleichspanungspositivpotentialanschlusselement DC2+ einstückig mit dem ersten Blechelement 7b der zweiten Gleichspannungsverschienung 7b ausgebildet ist und vorzugsweise das zweite Gleichspanungsnegativpotentialanschlusselement DC2- einstückig mit dem zweiten Blechelement 8b der zweiten Gleichspannungsverschienung 6b ausgebildet ist. Zwischen dem ersten und zweiten Blechelement 7b und 8b der zweiten Gleichspannungsverschienung 6b ist eine elektrisch nicht leitende zweite Isolationsschicht 9b (z.B. eine Kunststofffolie) angeordnet. Die zweite Isolationsschicht 9b kann zusätzlich zum zweiten Isolationselement I2 zwischen dem zweiten Gleichspanungspositivpotentialanschlusselement DC2+ und dem zweiten Gleichspanungsnegativpotentialanschlusselement DC2- angeordnet sein.

Zur elektrischen Verbindung des ersten und zweiten Gleichspanungspositivpotentialanschlusselements DC1+ und DC2+ miteinander und des ersten und zweiten Gleichspanungsnegativpotentialanschlusselement DC1- und DC2- miteinander, weist der Schaltschrank 1 die elektrische Verbindungsklemmeinrichtung 16 auf. Die Verbindungsklemmeinrichtung 16 weist ein elektrisch leitendes erstes Klemmelement 10 und ein elektrisch leitendes vom ersten Klemmelement 10 elektrisch isoliert angeordnetes zweites Klemmelement 11 und eine Druckerzeugungseinrichtung 12, die zum Erzeugen eines Drucks, der das zweite Klemmelement 11 in Richtung auf das erste Klemmelement 10 drückt, ausgebildet ist, aufweist. Die Druckerzeugungseinrichtung 12 drückt das zweite Klemmelement 11 gegen das erste und zweite Gleichspanungspositivpotentialanschlusselement DC1 + und DC2+, und drückt über das erste Gleichspanungspositivpotentialanschlusselement DC1+ und das erste Isolationselement I1, das erste Gleichspanungsnegativpotentialanschlusselement DC1- gegen das erste Klemmelement 10, und drückt über das zweite Gleichspanungspositivpotentialanschlusselement DC2+ und das zweite Isolationselement I2, das zweite Gleichspanungsnegativpotentialanschlusselement DC2- gegen das erste Klemmelement 10. Hierdurch wird das erste Klemmelement 10 mit dem ersten und zweiten Gleichspanungsnegativpotentialanschlusselement DC1- und DC2- elektrisch kontaktiert und das zweite Klemmelement 11 mit dem ersten und zweiten Gleichspanungspositivpotentialanschlusselement DC1+ und DC2+ elektrisch kontaktiert. Das erste und zweite Klemmelement 10 und 11 besteht vorzugsweise aus Kupfer. Das erste und zweite Klemmelement 10 und 11 weist vorzugsweise eine längliche Form auf.

Die Druckerzeugungseinrichtung 12 weist vorzugsweise zur Erzeugung des Drucks erste Schrauben 13 auf, die das erste und zweite Klemmelement 10 und 11 miteinander mechanisch verbinden, wobei die ersten Schrauben 13 von dem ersten oder dem zweiten Klemmelement 10 oder 11 elektrisch isoliert angeordnet sind. Beim Ausführungsbeispiel sind die ersten Schrauben 13 von dem zweiten Klemmelement 11 elektrisch isoliert angeordnet. Es sei angemerkt, dass im einfachsten Fall auch nur eine einzelne erste Schraube 13 vorhanden sein kann.

Falls, wie beim Ausführungsbeispiel, die ersten Schrauben 13 von dem ersten Klemmelement 10 elektrisch isoliert angeordnet sind, ist jeweilig zwischen den ersten Schrauben 13 und dem ersten Klemmelement 10 ein der jeweiligen ersten Schraube 13 zugeordneter elektrisch nicht leitender Isolationshohlkörper 14 angeordnet, durch den die jeweilige erste Schraube 13 verläuft. Falls die ersten Schrauben 13 von dem zweiten Klemmelement 11 elektrisch isoliert angeordnet sind, ist jeweilig zwischen den ersten Schrauben 13 und dem zweiten Klemmelement 10 ein der jeweiligen ersten Schraube 13 zugeordneter elektrisch nicht leitender Isolationshohlkörper 14 angeordnet, durch den die jeweilige erste Schraube 13 verläuft.

Vorzugsweise weist das erste Klemmelement 10 erste Löcher 15 und das zweite Klemmelement 11 zweite Löcher 17, deren Lochwand mit einem Innengewinde 30 versehen ist, auf, wobei die die ersten Schrauben 13 durch die ersten Löcher 15 verlaufen und in das Innengewinde 30 eingeschraubt sind. Es sei angemerkt, dass falls nur eine einzelne erste Schraube 13 vorhanden ist, auch nur ein einzelnes erstes Loch 15 und ein einzelnes Innengewinde 30 vorhanden sein kann.

Vorzugsweise weist das erste Klemmelement 10, wie beispielhaft in FIG 7 dargestellt, in Richtung des zweiten Klemmelements 11 hervorstehende erste Auswölbungen 20 auf und das zweite Klemmelement 11 in Richtung des ersten Klemmelements 10 hervorstehende zweite Auswölbungen 21 auf. Die ersten Auswölbungen 20 sind vorzugsweise an ihrer Oberfläche mit einer Riffelung 22 versehen und die zweiten Auswölbungen 21 sind vorzugsweise an ihrer Oberfläche mit einer Riffelung 23 versehen. Hierdurch wird eine besonders zuverlässige elektrische Kontaktierung der jeweiligen Auswölbung mit dem jeweiligen Gleichspanungspotentialanschlusselement (DC1+, DC2+, DC1-, DC2-) erzielt.

Das erste Klemmelement 10 ist erfindungsgemäß über einen elektrisch nicht leitenden Isolationskörper 19 vom Schrankgestell 2 elektrisch isoliert mit dem Schrankgestell 2 mechanisch verbunden. Die erste oder zweite Stromrichtereinrichtung 3a oder 3b können hierdurch schnell und einfach ausgetauscht werden, da das erste Klemmelement 10 bei einem Austausch der ersten oder zweiten Stromrichtereinrichtung 3a oder 3b fest mit dem Schrankgestell 2 verbunden bleibt und somit zum Austausch der ersten oder zweiten Stromrichtereinrichtung 3a bzw. 3b bezüglich der Verbindungsklemmeinrichtung 16 nur das zweite Klemmelement 11 entfernt werden muss. Die auszutauschende erste oder zweite Stromrichtereinrichtung 3a oder 3b kann in Richtung zur Frontseite des Schaltschranks 1 entnommen werden und anschließend eine neue Stromrichtereinrichtung an der Stelle der entnommenen Stromrichtereinrichtung im Schaltschrank angeordnet werden. Anschließend kann auf einfache Art und Weise die neue Stromrichtereinrichtung mit der im Schaltschrank 1 verbliebenen Stromrichtereinrichtung bezüglich ihrer Gleichspannungspotentialanschlusselemente elektrisch verbunden werden, indem das zweite Klemmelement 11 wieder angebracht wird und die Druckerzeugungseinrichtung 12, das zweite Klemmelement 11 in Richtung auf das erste Klemmelement 10 drückt.

Vorzugsweise ist das erste Klemmelement 11 über den elektrisch nicht leitenden Isolationskörper 19 vom Schrankgestell 2 elektrisch isoliert mit dem Schrankgestell 2 mechanisch verbunden, indem das erste Klemmelement 10 mittels einer Schraubverbindung 18 mit dem Isolationskörper 19 verbunden ist und der Isolationskörper 19 mittels einer weiteren Schraubverbindung 24 mit dem Schrankgestell 2 verbunden ist (siehe FIG 6). Der Isolationskörper 19 weist hierzu im Rahmen des Ausführungsbeispiels an seiner dem ersten Klemmelement 10 zugewandten Seite, ein erstes Innengewinde 25 auf, wobei eine zweite durch das erste Klemmelement 10 hindurchgehende Schraube 18' in das erste Innengewinde 25 eingeschraubt ist, und ein, an seiner der Stelle des Schrankgestells 2 an der der Isolationskörper 19 mit dem Schrankgestell 2 verbunden ist, zugewandten Seite, ein zweites Innengewinde 26 auf, wobei eine durch das Schrankgestell 2 hindurchgehende dritte Schraube 24' in das zweite Innengewinde 26 eingeschraubt ist. Der Isolationskörper 10 kann zur Realisierung des ersten und zweiten Innengewindes 25 und 26 Löcher aufweisen in die mit einem Innengewinde versehene Metallhülsen eingebracht sind. Die Metallhülsen sind der Übersichtlichkeit halber in FIG 6 nicht dargestellt. Im Rahmen des Ausführungsbeispiels wurden zur Befestigung des ersten Klemmelements am Schrankgestell zwei Isolationskörper verwendet, wobei hierzu auch noch mehr als zwei Isolationskörper verwendet werden können oder hierzu auch nur ein einzelner Isolationskörper verwendet werden kann.

Der die elektrische Isolation des Isolationskörper 10 bewirkende Teil des Isolationskörpers 10 besteht im Rahmen des Ausführungsbeispiels aus einem Polyesterverbundwerkstoff mit Glasfasern.

## Patentansprüche

1. Schaltschrank mit einem Schrankgestell (2) und mit einer ersten und einer zweiten im Schaltschrank (2) angeordneten Stromrichtereinrichtung (3a,3b), die vom Schrankgestell (2) getragen werden und mit einer elektrischen Verbindungsklemmeinrichtung (16), wobei die erste Stromrichtereinrichtung (3a) erste Leistungshalbleiterbauelemente (T1,D1) und zur elektrischen Verbindung der ersten Stromrichtereinrichtung (3a) ein erstes Gleichspanungspositivpotentialanschlusselement (DC1+) und ein erstes Gleichspanungsnegativpotentialanschlusselement (DC1-) aufweist, wobei zwischen dem ersten Gleichspanungspositivpotentialanschlusselement (DC1+) und dem ersten Gleichspanungsnegativpotentialanschlusselement (DC1-) ein elektrisch nicht leitendes erstes Isolationselement (I1) angeordnet ist, wobei die zweite Stromrichtereinrichtung (3b) zweite Leistungshalbleiterbauelemente (T2,D2) und zur elektrischen Verbindung der zweiten Stromrichtereinrichtung (6b) 3a ein zweites Gleichspanungspositivpotentialanschlusselement (DC2+) und ein zweites Gleichspanungsnegativpotentialanschlusselement (DC2-) aufweist, wobei zwischen dem zweiten Gleichspanungspositivpotentialanschlusselement (DC2+) und dem zweiten Gleichspanungsnegativpotentialanschlusselement (DC2-) ein elektrisch nicht leitendes zweites Isolationselement (I2) angeordnet ist, wobei die Verbindungsklemmeinrichtung (16) ein elektrisch leitendes erstes Klemmelement (10) und ein elektrisch leitendes vom ersten Klemmelement (10) elektrisch isoliert angeordnetes zweites Klemmelement (11) und eine Druckerzeugungseinrichtung (12), die zum Erzeugen eines Drucks, der das zweite Klemmelement (11) in Richtung auf das erste Klemmelement (10) drückt, ausgebildet ist, aufweist, wobei die Druckerzeugungseinrichtung (12) das zweite Klemmelement (11) gegen das erste und zweite Gleichspanungspositivpotentialanschlusselement (DC1+,DC2+) drückt, und über das erste Gleichspanungspositivpotentialanschlusselement (DC1+) und das erste Isolationselement (I1) das erste Gleichspanungsnegativpotentialanschlusselement (DC1-) gegen das erste Klemmelement (10) drückt, und über das zweite Gleichspanungspositivpotentialanschlusselement (DC2+) und das zweite Isolationselement (I2) das zweite Gleichspanungsnegativpotentialanschlusselement (DC2-) gegen das erste Klemmelement (10) drückt, wobei das erste Klemmelement (10) über einen elektrisch nicht leitenden Isolationskörper (19) vom Schrankgestell (2) elektrisch isoliert mit dem Schrankgestell (2) mechanisch verbunden ist.

2. Schaltschrank nach Anspruch 1, **dadurch gekennzeichnet, dass** die erste Stromrichtereinrichtung (3a) eine erste Gleichspannungsverschienung (6a) aufweist, die eine elektrisch leitendes erstes Blechelement (7a) und ein elektrisch leitendes, vom ersten Blechelement (7a) elektrisch isoliert angeordnetes zweites Blechelement (8a) aufweist, wobei das erste Gleichspanungspositivpotentialanschlusselement (DC1+) einstückig mit dem ersten Blechelement (7a) der ersten Gleichspannungsverschienung (6a) ausgebildet ist und das erste Gleichspanungsnegativpotentialanschlusselement (DC1-) einstückig mit dem zweiten Blechelement (8a) der ersten Gleichspannungsverschienung (6a) ausgebildet ist, wobei die zweite Stromrichtereinrichtung (3b) eine zweite Gleichspannungsverschienung (6b) aufweist, die eine elektrisch leitendes erstes Blechelement (7b) und ein elektrisch leitendes, vom ersten Blechelement (7b) elektrisch isoliert angeordnetes zweites Blechelement (8b) aufweist, wobei das zweite Gleichspanungspositivpotentialanschlusselement (DC2+) einstückig mit dem ersten Blechelement (7b) der zweiten Gleichspannungsverschienung (6b) ausgebildet ist und das zweite Gleichspanungsnegativpotentialanschlusselement (DC2-) einstückig mit dem zweiten Blechelement (8b) der zweiten Gleichspannungsverschienung (6b) ausgebildet ist.

3. Schaltschrank nach einem der vorgehenden Ansprüchen, **dadurch gekennzeichnet, dass** das erste Klemmelement (10) über den elektrisch nicht leitenden Isolationskörper (19) vom Schrankgestell (2) elektrisch isoliert mit dem Schrankgestell (2) mechanisch verbunden ist, indem das erste Klemmelement (10) mittels einer Schraubverbindung (18) mit dem Isolationskörper (19) verbunden ist und der Isolationskörper (19) mittels einer weiteren Schraubverbindung (24) mit dem Schrankgestell (2) verbunden ist.

4. Schaltschrank nach einem der vorgehenden Ansprüchen, **dadurch gekennzeichnet, dass** die Druckerzeugungseinrichtung (12) zur Erzeugung des Drucks eine erste Schraube (13) aufweist, die das erste und zweite Klemmelement (10,11) miteinander mechanisch verbindet, wobei die erste Schraube (13) von dem ersten oder dem zweiten Klemmelement (10,11) elektrisch isoliert angeordnet ist.

5. Schaltschrank nach Anspruch 4, **dadurch gekennzeichnet, dass** falls die erste Schraube (13) von dem ersten Klemmelement (10) elektrisch isoliert angeordnet ist, zwischen der ersten Schraube (13) und dem ersten Klemmelement (10) ein der ersten Schraube (13) zugeordneter elektrisch nicht leitender Isolationshohlkörper (14) angeordnet ist, durch den die erste Schraube (13) verläuft, und dass falls die erste Schraube (13) von dem zweiten Klemmelement (11) elektrisch isoliert angeordnet ist, zwischen der ersten Schraube (13) und dem zweiten Klemmelement (11) ein der ersten Schraube (13) zugeordneter elektrisch nicht leitender Isolationshohlkörper (14) angeordnet ist, durch den die erste Schraube (13) verläuft.

6. Schaltschrank nach einem der vorgehenden Ansprüchen, **dadurch gekennzeichnet, dass** das erste Klemmelement (10) in Richtung des zweiten Klemmelements (11) hervorstehende erste Auswölbungen (20) aufweist und das zweite Klemmelement (11) in Richtung des ersten Klemmelements (10) hervorstehende zweite Auswölbungen (21) aufweist.

7. Schaltschrank nach Anspruch 6, **dadurch gekennzeichnet, dass** die ersten und zweiten Auswölbungen (20,21) an ihrer Oberfläche mit einer Riffelung (22,23) versehen sind.

## Claims

1. Switchgear cabinet having a cabinet frame (2), and having a first and a second current converter device (3a, 3b) which are arranged in the switchgear cabinet (2) and are supported by the cabinet frame (2), and having an electrical connection clamping device (16), wherein the first current converter device (3a) has first power semiconductor components (T1, D1) and, for electrical connection of the first current converter device (3a), a first DC voltage positive potential connection element (DC1+) and a first DC voltage negative potential connection element (DC1-), wherein an electrically non-conductive first insulation element (I1) is arranged between the first DC voltage positive potential connection element (DC1+) and the first DC voltage negative potential connection element (DC1-), wherein the second current converter device (3b) has second power semiconductor components (T2, D2) and, for electrical connection of the second current converter device (6b)3a, a second DC voltage positive potential connection element (DC2+) and a second DC voltage negative potential connection element (DC2-), wherein an electrically non-conductive second insulation element (I2) is arranged between the second DC voltage positive potential connection element (DC2+) and the second DC voltage negative potential connection element (DC2-), wherein the connection clamping device (16) has an electrically conductive first clamping element (10) and an electrically conductive second clamping element (11), which is arranged such that it is electrically insulated from the first clamping element (10), and a pressure-generating device (12) which is designed to generate a pressure which pushes the second clamping element (11) in the direction of the first clamping element (10), wherein the pressure-generating device (12) pushes the second clamping element (11) against the first and second DC voltage positive potential connection elements (DC1+, DC2+) and, by means of the first DC voltage positive potential connection element (DC1+) and the first insulation element (I1), pushes the first DC voltage negative potential connection element (DC1-) against the first clamping element (10) and, by means of the second DC voltage positive potential connection element (DC2+) and the second insulation element (I2), pushes the second DC voltage negative potential connection element (DC2-) against the first clamping element (10), wherein the first clamping element (10) is mechanically connected to the cabinet frame (2) by means of an electrically non-conductive insulation body (19) such that it is electrically insulated from the cabinet frame (2).

2. Switchgear cabinet according to Claim 1, **characterized in that** the first current converter device (3a) has a first DC voltage rail arrangement (6a) which has an electrically conductive first sheet metal element (7a) and an electrically conductive second sheet metal element (8a) which is arranged such that it is electrically insulated from the first sheet metal element (7a), wherein the first DC voltage positive potential connection element (DC1+) is integrally formed with the first sheet metal element (7a) of the first DC voltage rail arrangement (6a), and the first DC voltage negative potential connection element (DC1-) is integrally formed with the second sheet metal element (8a) of the first DC voltage rail arrangement (6a), wherein the second current converter device (3b) has a second DC voltage rail arrangement (6b) which has an electrically conductive first sheet metal element (7b) and an electrically conductive second sheet metal element (8b) which is arranged such that it is electrically insulated from the first sheet metal element (7b), wherein the second DC voltage positive potential connection element (DC2+) is integrally formed with the first sheet metal element (7b) of the second DC voltage rail arrangement (6b), and the second DC voltage negative potential connection element (DC2-) is integrally formed with the second sheet metal element (8b) of the second DC voltage rail arrangement (6b).

3. Switchgear cabinet according to either of the preceding claims, **characterized in that** the first clamping element (10) is mechanically connected to the cabinet frame (2) by means of the electrically non-conductive insulation body (19) such that it is electrically insulated from the cabinet frame (2) by the first clamping element (10) being connected to the insulation body (19) by means of a screw connection (18), and the insulation body (19) being connected to the cabinet frame (2) by means of a further screw connection (24).

4. Switchgear cabinet according to one of the preceding claims, **characterized in that** the pressure-generating device (12) has, in order to generate the pressure, a first screw (13) which mechanically connects the first and second clamping element (10, 11) to one another, wherein the first screw (13) is arranged such that it is electrically insulated from the first or the second clamping element (10, 11).

5. Switchgear cabinet according to Claim 4, **characterized in that**, if the first screw (13) is arranged such that it is electrically insulated from the first clamping element (10), an electrically non-conductive hollow insulation body (14), which is associated with the first screw (13) and through which the first screw (13) runs, is arranged between the first screw (13) and the first clamping element (10), and **in that**, if the first screw (13) is arranged such that it is electrically insulated from the second clamping element (11), an electrically non-conductive hollow insulation body (14), which is associated with the first screw (13) and through which the first screw (13) runs, is arranged between the first screw (13) and the second clamping element (11).

6. Switchgear cabinet according to one of the preceding claims, **characterized in that** the first clamping element (10) has first convex portions (20) which project in the direction of the second clamping element (11), and the second clamping element (11) has second convex portions (21) which project in the direction of the first clamping element (10).

7. Switchgear cabinet according to Claim 6, **characterized in that** the first and second convex portions (20, 21) are provided with a fluting (22, 23) on their surface.

## Revendications

1. Armoire pour convertisseur de puissance avec un châssis d'armoire (2) et avec un premier et un deuxième système de redresseur (3a,3b) disposés dans l'armoire pour convertisseur de puissance (2), qui sont supportés par le châssis d'armoire (2) et avec un système électrique de serrage de jonction (16), le premier système de redresseur (3a) comportant des premiers éléments de construction à semi-conducteurs de puissance (T1,D1) et pour liaison électrique du premier système de redresseur (3a) un premier élément de connexion à potentiel positif à tension continue (CC1+) et un premier élément de connexion à potentiel négatif à tension continue (CC1-), un premier élément d'isolation (I1) non électroconducteur étant disposé entre le premier élément de connexion à potentiel positif à tension continue (CC1+) et le premier élément de connexion à potentiel négatif à tension continue (CC1-), le deuxième système de redresseur (3b) comportant des deuxièmes éléments de construction à semi-conducteurs de puissance (T2,D2) et pour liaison électrique du deuxième système de redresseur (6b) 3a un deuxième élément de connexion à potentiel positif à tension continue (CC2+) et un deuxième élément de connexion à potentiel négatif à tension continue (CC2-), un deuxième élément d'isolation (I2) non électroconducteur étant disposé entre le deuxième élément de connexion à potentiel positif à tension continue (CC2+) et le deuxième élément de connexion à potentiel négatif à tension continue (CC2-), le système de serrage de jonction (16) comportant un premier élément de serrage (10) électroconducteur et un deuxième élément de serrage (11) électroconducteur disposé de façon électriquement isolée du premier élément de serrage (10) et un système de production de pression (12), configuré pour produire une pression, qui apppuie le deuxième élément de serrage (11) en direction du premier élément de serrage (10), le système de production de pression (12) appuyant le deuxième élément de serrage (11) contre le premier et le deuxième élément de connexion à potentiel positif à tension continue (CC1+, CC2+) et appuyant le premier élément de connexion à potentiel négatif à tension continue (CC1-) par le biais du premier élément de connexion à potentiel positif à tension continue (CC1+) et du premier élément d'isolation (I1) contre le premier élément de serrage (10) et appuyant le deuxième élément de connexion à potentiel négatif à tension continue (CC2-) par le biais du deuxème élément de connexion à potentiel positif à tension continue (CC2+) et du deuxième élément d'isolation (I2) contre le premier élément de serrage (10), le premier élément de serrage (10) étant relié mécaniquement au châssis d'armoire (2) isolé électriquement du châssis d'armoire (2) par le biais d'un corps d'isolation (19) non électroconducteur.

2. Armoire pour convertisseur de puissance selon la revendication 1, **caractérisée en ce que** le premier système de redresseur (3a) comporte un premier agencement de barres à tension continue (6a), qui comporte un premier élément en tôle (7a) électroconducteur et un deuxième élément en tôle (8a) disposé de façon électriquement isolée du premier élément en tôle (7a), le premier élément de connexion à potentiel positif à tension continue (CC1+) étant configuré en une seule pièce avec le premier élément en tôle (7a) du premier agencement à barres à tension continue (6a) et le premier élément de connexion à potentiel négatif à tension continue (CC1-) étant configuré en une seule pièce avec le deuxième élément en tôle (8a) du premier agencement à barres à tension continue (6a), le deuxième système de redresseur (3b) comportant un deuxième agencement à barres à tension continue (6b), qui comporte un premier élément en tôle (7b) électroconducteur et un deuxième élément en tôle (8b) électroconducteur, disposé de façon électriquement isolée du premier élément en tôle (7b), le deuxième élément de connexion à potentiel positif à tension continue (CC2+) étant configuré en une seule pièce avec le premier élément en tôle (7b) du deuxième agencement à barres à tension continue (6b) et le deuxième élément de connexion à potentiel négatif à tension continue (CC2-) étant configuré en une seule pièce avec le deuxième élément en tôle (8b) du deuxième agencement à barres à tension continue (6b).

3. Armoire pour convertisseur de puissance selon l'une quelconque des revendications précédentes, **caractérisée en ce que** le premier élément de serrage (10) est relié mécaniquement au châssis d'armoire (2) électriquement isolé du châsis d'armoire (2) par le biais du corps d'isolation (19), non électroconducteur, **en ce que** le premier élément de serrage (10) est relié au moyen d'une liaison à vis (18) au corps d'isolation (19) et le corps d'isolation (19) au châssis d'armoire (2) au moyen d'une autre liaison à vis (24).

4. Armoire pour convertisseur de puissance selon l'une quelconque des revendications précédentes, **caractérisée en ce que** le système de production de pression (12) comporte une première vis (13) pour produire la pression, qui relie mécaniquement entre eux le premier et le deuxième élément de serrage (10,11), la première vis (13) étant disposée de façon électriquement isolée du premier ou du deuxième élément de serrage (10,11).

5. Armoire pour convertisseur de puissance selon la revendication 4, **caractérisée en ce qu'**au cas où la première vis (13) est disposée de façon électriquement isolée du premier élément de serrage (10), un corps creux d'isolation non électroconducteur (14) attribué à la première vis (13) est disposé entre la première vis (13) et le premier élément de serrage (10) à travers lequel passe la première vis (13) et **en ce qu'**au cas où la première vis (13) est disposée électriquement isolée du deuxième élément de serrage (11), un corps creux d'isolation non électroconducteur (14) attribué à la première vis (13) est disposé entre la première vis (13) et le deuxième élément de serrage (11) à travers lequel passe la première vis (13).

6. Armoire pour convertisseur de puissance selon l'une quelconque des revendications précédentes, **caractérisée en ce que** le premier élément de serrage (10) comporte en direction du deuxième élément de serrage (11) des premiers bombements (20) faisant saillie et le deuxième élément de serrage (11) comporte en direction du premier élément de serrage (10) des deuxièmes bombements (21) faisant saillie.

7. Armoire pour convertisseur de puissance selon la revendication 6, **caractérisée en ce que** les premiers et deuxièmes bombements (20,21) sont dotés sur leur surface d'une cannelure (22,23).
